Europäisches Patentamt

European Patent Office

Office européen des brevets

(11) Veröffentlichungsnummer : **0 063 204**
**B1**

(12) # EUROPÄISCHE PATENTSCHRIFT

(45) Veröffentlichungstag der Patentschrift :
18.09.85

(51) Int. Cl.⁴ : **H 03 D   3/24**

(21) Anmeldenummer : **82100024.7**

(22) Anmeldetag : **05.01.82**

(54) **Schaltungsanordnung für einen FM-Demodulator.**

(30) Priorität : **10.04.81 DE 3114595**

(43) Veröffentlichungstag der Anmeldung :
**27.10.82 Patentblatt 82/43**

(45) Bekanntmachung des Hinweises auf die Patenterteilung : **18.09.85 Patentblatt 85/38**

(84) Benannte Vertragsstaaten :
**AT CH DE FR GB IT LI NL**

(56) Entgegenhaltungen :
**DE-B- 2 200 883**
**US-A- 4 117 410**
**WIRELESS WORLD, Band 85, Nr. 1525, September
1979, Haywards Heath, England, J.L. LINSLEY HOOD
"Linear Voltage-Controlled Oscillator", Seiten 87-88
NACHRICHTEN ELEKTRONIK, Band 35, Br. 5, 1981,
Heidelberg, D. MÖLLER "Grundlagen und Anwendung des PLL-Verfahrens", Seiten 187-194**

(73) Patentinhaber : **GRUNDIG E.M.V. Elektro-Mechanische Versuchsanstalt Max Grundig holländ. Stiftung &
Co. KG.
Kurgartenstrasse 37
D-8510 Fürth (DE)**

(72) Erfinder : **Bauerschmidt, Werner, Ing. grad.
Burgfarrnbacher Strasse 20b
D-8502 Zirndorf (DE)**

## Beschreibung

Die Erfindung betrifft eine Schaltungsanordnung für einen als FM-Demodulator zu betreibenden Phasenregelkreis, der aus einem integrierten Phasendetektor mit Begrenzerverstärker, einem spannungsgesteuerten Oszillator mit Kapazitätsdiodenabstimmung und einem zur Kapazitätsdiode in Reihe geschalteten Kondensator, sowie einem Schleifenfilter besteht, und bei dem Linearität und Nulldurchgang der Demodulatorkennlinie unabhängig voneinander einstellbar sind.

Es ist grundsätzlich bekannt, Phasenregelkreise (PLL-Schaltungen) zur FM-Demodulation zu verwenden. Ein entsprechend aufgebauter PLL-Demodulator besteht aus einem Multiplizierer, einem Tiefpaß (Schleifenfilter) und einem spannungsgesteuerten Oszillator (VCO). Hierbei bilden Multiplizierer und Tiefpaß zusammen einen Phasendetektor, dessen Ausgangssignal eine der momentanen Phasendifferenz zwischen Oszillator- und Eingangssignal entsprechende Spannung ist. Mit Hilfe dieser Spannung soll die Momentanphase des Eingangssignals nachgeregelt werden. Sind die Momentanphasen beider Signale synchronisiert, so spricht man von einer „eingerasteten" PLL. Besteht zwischen der Steuerspannung und der Frequenz des spannungsgesteuerten Oszillators ein linearer Zusammenhang, so ist die Steuerspannung, die gleich der Ausgangsspannung des Multiplizierers ist, ein Abbild des Eingangssignals und stellt somit ein demoduliertes Signal dar. Nachteilig ist, daß ein über eine Kapazitätsdiode gesteuerter Oszillator mit linearer Spannungs-Frequenz-Kennlinie im Frequenzbereich einer Zwischen-frequenz von z. B. 10,7 MHz ohne besondere Linearisierungsmaßnahmen nicht zu realisieren ist.

Aus der Zeitschrift „Wireless World", Band 85, Nr. 1525, Sept. 1979, Seiten 87 und 88, ist unter dem Titel „Linear Voltage-Controlled Oscillator" eine Einrichtung bekannt, mit der dieser Nachteil behoben werden kann. Dort wird der nichtlineare Spannungs-Kapazitäts-Kennlinienverlauf der Abstimmdiode mittels einer dazu komplementären Transistorkennlinie linearisiert. Die hierzu erforderliche Transistorschaltung ist in der Abstimmspannungszuführung der Kapazitätsdiode angeordnet.

Derartige Linearisierungsmaßnahmen in der Abstimmspannungszuführung sind jedoch bei hohen Anforderungen an die Linearität der Demodulatorkennlinie technisch und wirtschaftlich sehr aufwendig.

Der Erfindung liegt daher die Aufgabe zugrunde, eine Schaltungsanordnung für einen FM-Demodulator zu schaffen, die die grundlegendsten Qualitätskriterien eines Demodulators mit geringem Schaltungsaufwand erfüllen. Diese Aufgabe wird durch das Kennzeichen des Patentanspruchs 1 erfüllt.

Bei der erfindungsgemäßen Schaltung wird davon ausgegangen, daß ein herkömmlicher spannungsgesteuerter LC-Oszillator, der mit Hilfe einer Kapazitätsdiode gesteuert werden kann, ohne besondere Maßnahmen eine nichtlineare Spannungs-Frequenz-Kennlinie aufweist. Wird jedoch in Serie zur Abstimmdiode ein Kondensator geschaltet, so wird deren Kapazitätshub verkürzt, und es ergibt sich eine Streckung der Spannungs-Frequenz-Kennlinie des Oszillators und teils ein Wendepunkt in deren Verlauf. Verschiebt man den Kurvenverlauf dieser Kennlinie durch Variation der Oszillatorinduktivität, so ergibt sich ein Punkt mit geringsten Nichtlinearitäten, d. h. ein Klirrfaktorminimum der gesamten Demodulatorschaltung. Bei einer Mittenfrequenz am Eingang des Multiplizierers stellt sich im allgemeinen eine von Null verschiedene Ausgangsspannung ein. Da der Nulldurchgang dieser Spannung bei Mittenfrequenzen jedoch ein wichtiges Kriterium für die Abstimmung von z. B. FM-Rundfunkempfängern ist, ist es erforderlich, die entstandene Fehlspannung auszugleichen. Nach der Schaltung gemäß der dargestellten Figur geschieht dieses dadurch, daß am Fußpunkt der Kapazitätsdiode eine Spannung so eingestellt wird, daß sich am Demodulatorausgang bei einer Eingangsmittenfrequenz eine Spannung Null ergibt und so durch den sich darstellenden Nulldurchgang der Demodulatorkennlinie mit der Mittenfrequenz des zu demodulierenden Signals zusammenfällt. Somit erfüllt die erfindungsgemäße Demodulatorschaltung die nach der Aufgabenstellung geforderten grundlegendsten Qualitätskriterien mit sehr geringem Aufwand.

In der dargestellten Figur wird das Eingangssignal $E_S$ einem integrierten Schaltkreis $S_I$, der aus einem Begrenzerverstärker und einem Phasendetektor gebildet ist, zugeführt. Über den Ausgang des Schaltkreises $S_I$ wird das Signal $A_S$ des Phasendetektors über ein Schleifenfilter $R_{L1}$, $C_L$, $R_{L2}$ und einen der Entkopplung dienenden Widerstand $R_E$ an den Verbindungspunkt zwischen einer Kapazitätsdiode $D_1$ und einem Kondensator $C_V$ geführt. Die Kapazitätsdiode $D_1$ ist hierbei als Abstimmdiode eingesetzt. Der Kondensator $C_V$ verändert bzw. verkürzt den Kapazitätshub der Abstimmdiode. Über einen regelbaren Widerstand $R_R$ ist die Spannung $U_K$ am Fußpunkt der Kapazitätsdiode $D_1$ einstellbar. Der regelbare Widerstand $R_R$ liegt mit seinem einen Fußpunkt über einen weiteren Widerstand $R_{R1}$ an der Versorgungsspannung $U_B$ und mit seinem anderen Fußpunkt an Masse. Über einen Abgriff am Widerstand $R_R$ und über einen weiteren Widerstand $R_{R2}$ wird die veränderbare Spannung $U_K$ der Kapazitätsdiode $D_1$ zugeführt. Über wenigstens einen Siebkondensator $C_S$ liegt der Fußpunkt der Kapazitätsdiode $D_1$ an Masse.

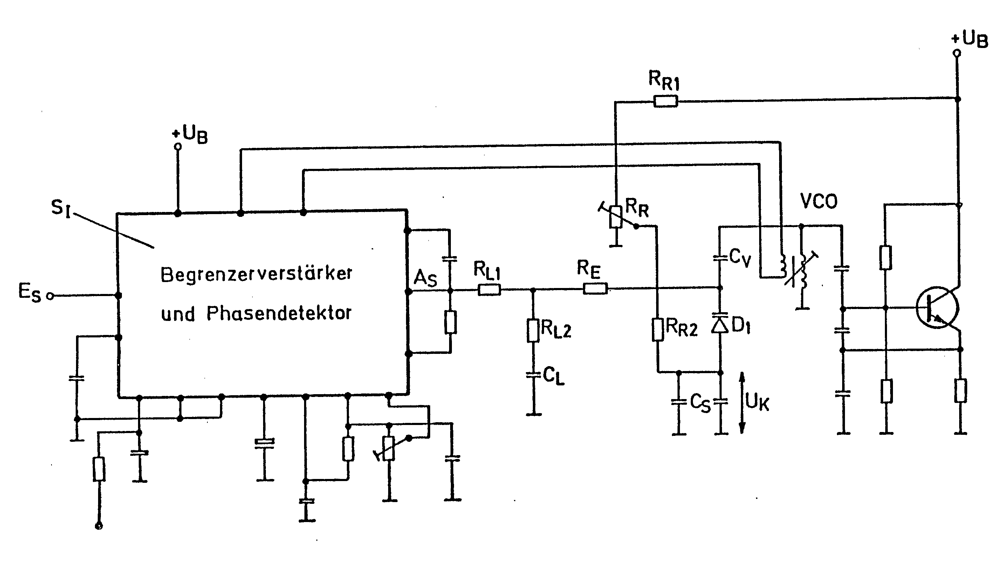

## Patentansprüche

1. Schaltungsanordnung für einen als FM-Demodulator zu betreibenden Phasenregelkreis, der aus einem integrierten Phasendetektor mit Begrenzerverstärker ($S_I$), einem spannungsgesteuerten Oszillator (VCO) mit Kapazitätsdiodenabstimmung ($D_1$) und einem zur Kapazitätsdiode in Reihe geschalteten Kondensator ($C_V$), sowie einem Schleifenfilter ($R_{L1}$, $R_{L2}$, $C_L$) besteht, und bei dem Linearität und Nulldurchgang der Demodulatorkennlinie unabhängig voneinander einstellbar sind, dadurch gekennzeichnet, daß der in Reihe zur Kapazitätsdiode ($D_1$) geschaltete Kondensator ($C_V$) den von der Abstimmspannungsänderung abhängigen Kapazitätshub der Kapazitätsdiode derart verkürzt und die Spannungs-Frequenz-Kennlinie des Oszillators derart dehnt, daß die Linearisierung der Demodulatorkennlinie ausschließlich über diesen Kondensator erfolgt, und daß der Nulldurchgang der Demodulatorkennlinie über einen regelbaren Widerstand ($R_R$) eingestellt wird, der eine veränderbare Gleichspannung ($U_K$) an den Fußpunkt der Kapazitätsdiode legt.

2. Schaltungsanordnung nach Anspruch 1, dadurch gekennzeichnet, daß der regelbare Widerstand ($R_R$) einerseits über einen Widerstand ($R_{R1}$) an der Versorgungsspannung ($U_B$) und andererseits an Masse liegt, während ein Abgriff über einen Widerstand ($R_{R2}$) mit dem Fußpunkt der Kapazitätsdiode ($D_1$) verbunden ist.

3. Schaltungsanordnung nach den Ansprüchen 1 und 2, dadurch gekennzeichnet, daß wenigstens ein Siebkondensator ($C_S$) vom Fußpunkt der Kapazitätsdiode ($D_1$) an Masse liegt.

## Claims

1. Circuit arrangement for a phase control circuit which is to be operated as FM demodulator and which consists of an integrated phase detector comprising a limiter amplifier ($S_I$), a voltage-controlled oscillator (VCO) comprising voltage-variable capacitor tuning ($D_1$) and a capacitor ($C_V$) which is connected in series with the voltage-variable capacitor, and a loop filter ($R_{L1}$, $R_{L2}$, $C_L$), and in which linearity and zero transition of the demodulator characteristic can be adjusted independently of each other, characterised in that the capacitor ($C_V$) connected in series with the voltage-variable capacitor ($D_1$) shortens the capacitance range, which is a function of the change of tuning voltage, of the voltage-variable capacitor in such a manner, and extends the voltage/frequency characteristic of the oscillator in such a manner that the demodulator characteristic is linearised exclusively via this capacitor, and that the zero transition of the demodulator characteristic is adjusted via a controllable resistor ($R_R$) which applies a variable direct voltage ($U_K$) to the low end of the voltage-variable capacitor.

2. Circuit arrangement according to Claim 1, characterised in that the controllable resistor ($R_R$) is connected, on the one hand, via a resistor ($R_{R1}$) to the supply voltage ($U_B$) and, on the other hand, to earth, whilst a tap is connected via a resistor ($R_{R2}$) to the low end of the voltage-variable capacitor ($D_1$).

3. Circuit arrangement according to Claims 1 and 2, characterised in that at least one filter capacitor ($C_S$) is connected from the low end of the voltage-variable capacitor ($D_1$) to earth.

## Revendications

1. Montage pour un circuit de réglage de phase, qui doit fonctionner en tant que démodulateur FM et qui est constitué par un détecteur de phase intégré comportant un amplificateur de limitation ($S_I$), par un oscillateur (VCO) commandé par la tension et comportant un système d'accord à diode capacitive ($D_1$) et par un condensateur ($C_V$) branché en série avec la diode capacitive, ainsi que par un filtre de boucle ($R_{L1}$, $R_{L2}$, $C_L$), et dans lequel la linéarité et le passage à zéro de la courbe caractéristique du démodulateur sont réglables d'une manière indépendante l'une de l'autre, caractérisé en ce que le condensateur ($C_V$) branché en série avec la diode capacitive ($D_1$) réduit la plage de variation, dépendant de la variation de la tension d'accord, de la capacité de la diode capacitive et allonge la courbe caractéristique tension-fréquence de l'oscillateur de telle sorte que la linéarisation de la courbe caractéristique du démodulateur s'effectue exclusivement par l'intermédiaire de ce condensateur et que le passage par zéro de la courbe caractéristique du démodulateur est réglé par l'intermédiaire d'une résistance réglable ($R_R$), qui applique une tension continue variable ($U_K$) à l'anode de la diode capacitive.

2. Montage selon la revendication 1, caractérisé en ce que la résistance réglable ($R_R$) est raccordée d'une part par l'intermédiaire d'une résistance ($R_{R1}$), à la tension d'alimentation ($U_B$) et d'autre part à la masse, tandis qu'une prise est reliée par l'intermédiaire d'une résistance ($R_{R2}$) à l'anode de la diode capacitive ($D_1$).

3. Montage selon les revendications 1 et 2, caractérisé en ce qu'au moins un condensateur de lissage ($C_S$) est raccordé entre l'anode de la diode capacitive ($D_1$) et la masse.